# EUROPEAN PATENT APPLICATION

(11) **EP 4 668 536 A1**
(43) Date of publication of application: **24.12.2025**
(21) Application number: 24877477.0
(22) Date of filing: 07.10.2024
(51) Int. Cl.: H02J 7/00, B60L 58/26, H01M 10/613, H01M 10/6563, H05K 7/20, H01R 11/28, H01R 13/04, H01R 13/533

(54) **CHARGE/DISCHARGE APPARATUS FOR SECONDARY BATTERY**

(30) Priority: 13.10.2023 KR 20230137096
(71) Applicant: LG Energy Solution, Ltd., Seoul 07335 (KR)
(72) Inventor: KIM, Myung-Ki, Daejeon 34122 (KR)
(74) Representative: Goddar, Heinz J.
(86) International application number: PCT/KR2024/015192
(87) International publication number: WO 2025/079939

(57) **Abstract**

Provided is a charging and discharging device for secondary batteries with an improved internal airflow. A charging and discharging device of the present disclosure includes a mechanism unit that brings pins for charging and discharging into contact with battery cells; a power supply unit that is disposed adjacent to the mechanism unit, supplies power and controls charging and discharging; and an airflow circulation unit that continuously circulates air through the power supply unit to the mechanism unit.

## Description

### TECHNICAL FIELD

The present disclosure relates to a charging and discharging device for secondary batteries, and more particularly, to a charging and discharging device improved to be capable of efficiently cooling the inside of the charging and discharging device. This application is based on and claims priority from Korean Patent Application No. 10-2023-0137096 filed on October 13, 2023, with the Korean Intellectual Property Office, the disclosure of which is incorporated herein in its entirety by reference.

### BACKGROUND ART

Secondary batteries having high applicability according to product groups and electrical characteristics such as high energy density are commonly applied not only to portable devices but also to electric vehicles (EVs) or hybrid electric vehicles (HEVs) driven by electric power sources. Such secondary batteries are attracting attention as a new energy source to improve eco-friendliness and energy efficiency in that they have not only a primary advantage of dramatically reducing the use of fossil fuels, but also no by-products generated from the use of energy.

Lithium-ion batteries are typical of secondary batteries, and the operating voltage of such a unit secondary battery cell, that is, a unit battery cell, is about 2.5 V to 4.5 V. Therefore, when a higher output voltage is required, a plurality of battery cells may be connected in series to configure a battery pack. Additionally, depending on the charging and discharging capacity required for a battery pack, a plurality of battery cells may also be connected in parallel to configure a battery pack. Thus, the number of battery cells included in the battery pack may be variously set depending on the required output voltage or charging and discharging capacity.

Secondary batteries are manufactured through an assembly process and an activation process. Since secondary batteries are assembled in a discharged state, the secondary batteries should be assembled and then charged to activate them so that they may function as batteries. Therefore, after the secondary battery assembly process, a formation process that performs charging and discharging to provide excellent charging and discharging characteristics to the assembled secondary batteries is performed, and an evaluation process including a capacity test to check whether the charging and discharging capacity is sufficient is performed. At this time, the activation process is usually performed by a charging and discharging device having positive electrode and negative electrode contact pins applying the necessary current to the battery cell to be charged and discharged.

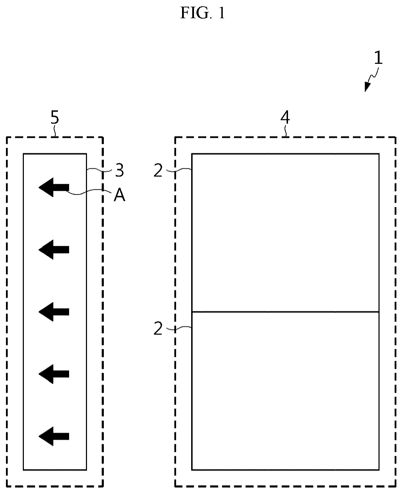

FIG. 1 is a view for describing a conventional charging and discharging device.

The conventional charging and discharging device 1 includes a mechanism unit 2 and a power supply unit 3, as shown in FIG. 1. The mechanism unit 2 is for bringing pins into contact with battery cells, and the power supply unit 3 is for controlling power and charging and discharging, and conventionally, the mechanism unit 2 is disposed in a formation room 4, and the power supply unit 3 is disposed in a management room 5, so they are physically separated from each other in separate spaces.

Heat generated during the charging and discharging operation includes battery cell heat in the mechanism unit 2 and charging and discharging heat in the power supply unit 3. When the battery cell is charged and discharged, heat is generated in the battery cell by charging and discharging. And, heat is also generated in the power supply unit 3 that supplies power and controls charging and discharging.

In the conventional charging and discharging device 1, the mechanism unit 2 does not have a separate cooling device. The power supply unit 3 includes a fan to discharge the heated air inside the power supply unit 3 to the outside (the direction of air discharge is indicated by arrow A). The heated air discharged to the outside is sent to the factory air conditioning device to be discharged to the outside of the factory or used to maintain the temperature inside the factory at a certain level.

However, depending on the facility arrangement of the factory air conditioning device or the charging and discharging device 1, air circulation inside the factory may not be good, and the temperature in a certain location inside the factory may be higher than in other locations. And, since the conventional charging and discharging device 1 does not actively manage the airflow inside the device, the degree of cooling may vary depending on the location of the battery cell in the mechanism unit 2, thereby causing temperature deviations, which may lead to a problem of deviations in the capacity and voltage drop of the battery cell.

Meanwhile, the layout of the conventional charging and discharging device 1 is a vertical stacking of two boxes of the mechanism unit 2. One tray of battery cells is inserted per box, and the battery cells are brought into contact with the pins to perform charging and discharging. As such, conventionally, there is a limited facility layout in which the number of boxes that can be installed is determined depending on the design height of one box and the height at which the facility can be installed inside the factory.

### DISCLOSURE

### Technical Problem

The present disclosure is designed to solve the problems of the related art, and therefore the present disclosure is directed to providing a charging and discharging device for secondary batteries with an improved internal airflow.

The present disclosure is also directed to providing a charging and discharging device for secondary batteries with an improved layout.

### Technical Solution

A charging and discharging device of the present disclosure for solving the above problem includes a mechanism unit that brings pins for charging and discharging into contact with battery cells; a power supply unit that is disposed adjacent to the mechanism unit, supplies power and controls charging and discharging; and an airflow circulation unit that continuously circulates air through the power supply unit to the mechanism unit.

Preferably, air within the airflow circulation unit may be connected to a factory air conditioning device and circulated.

In the charging and discharging device according to the present disclosure, the mechanism unit may include a pin box portion accommodating the pins, and the pin box portion may be provided with an air circulation passage in a direction in which the air flows.

The mechanism unit may include a pin box portion accommodating the pins, and in the pin box portion, a voltage conversion/charge/discharge control board, an interface board, a riser board, and the pins may be directly connected by a connector method.

Preferably, the pin box portion is provided with an air circulation passage in a direction in which the air flows between the voltage conversion/charge/discharge control board, the interface board, and the riser board.

A tray on which battery cells are seated may be loaded in the mechanism unit, and the tray may have a side that is open in a direction in which the air flows.

For solving the above other problem, two or more trays may be loaded in the mechanism unit in the upward and downward directions.

The mechanism unit may include an upper pin box portion and a lower pin box portion that accommodate the pins; an upper support portion that supports the upper pin box portion; a lower support portion that supports the lower pin box portion and on which an upper tray is seated; and a base portion on which a lower tray is seated.

At this time, the mechanism unit may further include an upper elevating portion formed to extend upward from the lower support portion; and a lower elevating portion formed to extend upward from the base portion, wherein the upper support portion may be seated on top of the upper elevating portion, and the lower support portion may be seated on top of the lower elevating portion.

In an embodiment, a supply and a return of a factory air conditioning device are provided above the mechanism unit and the power supply unit, and the airflow circulation unit includes a pair of ducts, wherein an intake port for introducing air supplied from the supply of the factory air conditioning device is installed at an upper side of the duct on one side, and an exhaust port for discharging the air to the return of the factory air conditioning device is installed at an upper side of the duct on the other side.

At this time, it is preferable that the power supply unit is located in the duct on one side.

Air introduced from the intake port may be diffused in the mechanism unit and then discharged toward the exhaust port.

The charging and discharging device according to the present disclosure may further include an inlet fan for blowing air introduced from the intake port toward the mechanism unit, and an outlet fan for blowing air diffused in the mechanism unit toward the exhaust port.

A tray may be loaded in the mechanism unit, and a ventilation hole may be installed in the tray, so that air introduced from the intake port may be discharged toward the exhaust port through the ventilation hole.

The mechanism unit may be stacked in multiple stages in the upward and downward directions.

The charging and discharging device may further include a heat exchanger in the duct on the other side.

According to another embodiment of the present disclosure, the charging and discharging device may further include an upper stopper installed on the lower support portion; and a lower stopper installed on the base portion.

Furthermore, the charging and discharging device may further include an upper stopper installed on the lower support portion; and a lower stopper installed on the base portion.

When the upper pin box portion and the upper support portion are lowered by the upper elevating portion and touch the upper stopper, pins of the upper pin box portion may be brought into contact with battery cells in the upper tray.

And, when the upper pin box portion, the upper support portion, the upper tray, and the lower support portion are lowered and touch the lower stopper, pins of the lower pin box portion may be brought into contact with battery cells in the lower tray.

In addition, guide pins may be installed at the bottom of the upper pin box portion and the bottom of the lower pin box portion, respectively, and grooves suitable for the guide pins may be provided in the upper tray and the lower tray, respectively.

### Advantageous Effects

According to the present disclosure, the internal airflow and layout of the charging and discharging device may be improved.

According to one configuration of the present disclosure, there is an advantage in that internal temperature inside the factory may be smoothly maintained by installing a duct in a place connected to the supply and return of the factory air conditioning device.

According to the present disclosure, air may be circulated through a duct directly connected to a factory air conditioning device, and in particular, downward airflow, upward airflow, and horizontal airflow are all used for circulation, thereby cooling the power supply unit and the mechanism unit more efficiently.

As described above, according to the present disclosure, there is provided a charging and discharging device improved to be capable of cooling the inside of the charging and discharging device with air more efficiently.

According to the present disclosure, air may be efficiently circulated so as to reduce temperature deviations between battery cells while charging and discharging the battery cells.

According to the present disclosure, air discharged from the mechanism unit through the airflow circulation unit may be recycled by heat exchange in a heat exchanger. For example, hot water may be produced through the heat exchanger and utilized where necessary in a factory.

According to another configuration of the present disclosure, the number of charging and discharging devices that can be installed within a given height increases.

According to still another configuration of the present disclosure, when two or more trays are loaded inside the mechanism unit in the upward and downward directions by improving the layout, there is also an advantage in that it becomes easy to adjust the spacing between the pin box portion and the tray and to perform alignment between the trays.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a view for describing a conventional charging and discharging device.
FIG. 2 is a view for describing a charging and discharging device according to a first embodiment of the present disclosure.
FIG. 3 is a front view of a charging and discharging device according to a second embodiment of the present disclosure.
FIG. 4 is a front view of a pin box portion that can be included in the charging and discharging device of FIG. 3.
FIG. 5 is a side view of the pin box portion shown in FIG. 4.
FIG. 6 is a top view of the pin box portion shown in FIG. 4.
FIG. 7 is a front view of a charging and discharging device according to a third embodiment of the present disclosure.
FIG. 8 is a front view of a charging and discharging device according to a fourth embodiment of the present disclosure.
FIGS. 9 to 12 are views for describing a charging and discharging device according to a fifth embodiment of the present disclosure.

### BEST MODE

Hereinafter, preferred embodiments of the present disclosure will be described in detail with reference to the accompanying drawings. Prior to the description, it should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the embodiment described in this specification and the configuration shown in the drawings are only a most preferred embodiment of the present disclosure, not intended to entirely represent the technical aspects of the present disclosure, so it should be understood that various equivalents and modifications may be made thereto at the time of filing the present application.

In the drawings, the size of each component or a specific portion constituting the component is exaggerated, omitted, or schematically illustrated for convenience and clarity of description. Therefore, the size of each component does not fully reflect the actual size. If it is determined that a detailed description of a related known function or configuration may unnecessarily obscure the gist of the present disclosure, such a description will be omitted. Furthermore, since the same reference numerals refer to the same members, any descriptions that are redundant or repeated in various embodiments will be omitted.

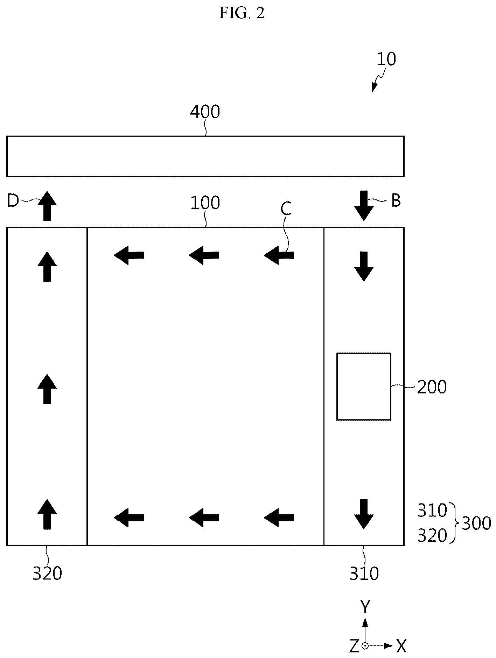

FIG. 2 is a view for describing a charging and discharging device according to a first embodiment of the present disclosure.

Referring to FIG. 2, the charging and discharging device 10 includes a mechanism unit 100, a power supply unit 200, and an airflow circulation unit 300.

The mechanism unit 100 is configured to bring pins for charging and discharging into contact with battery cells. The power supply unit 200 is disposed adjacent to the mechanism unit 100, and is configured to supply power and control charging and discharging.

Unlike the conventional charging and discharging device 10, the mechanism unit 100 and the power supply unit 200 are integrated rather than physically separated in separate spaces. To minimize the number of connection points, the mechanism unit 100 and the power supply unit 200 of the charging and discharging device 10 are integrated and installed. Airflow circulation may proceed more effectively only by minimizing the number of connection points.

The airflow circulation unit 300 continuously circulates air through the power supply unit 200 to the mechanism unit 100. The airflow circulation unit 300 may include a pair of ducts 310, 320. Preferably, the air in the airflow circulation unit 300 is connected to a factory air conditioning device 400 and circulated.

The pair of ducts 310, 320 may be spaced apart from each other in the X-axis direction and installed upright in the Y-axis direction, for example. The space between the pair of ducts 310, 320 may be configured as a housing. This housing may be in the form of a box having an internal space capable of accommodating the mechanism unit 100. Although the present disclosure is not limited by such a housing, the housing may include a ceiling (top in the Y-axis direction), a bottom (bottom in the Y-axis direction), side portions (left and right in the X-axis direction), and front and rear portions (front and rear in the Z-axis direction), wherein the side portions may have an open structure connected to the ducts 310, 320. Openings may also be formed in the front and rear portions. Through these openings, a tray on which battery cells are mounted may be put into or taken out of the housing. The openings may be provided with a retractable door.

In the drawing, the airflow direction is shown by arrows B, C, D. The factory air conditioning device 400 may be located on the ceiling of the housing. Air is introduced from the factory air conditioning device 400 to one side of the airflow circulation unit 300 (airflow in the B direction, -Y-axis direction, so descending airflow), and at this time, the power supply unit 200 is installed in the airflow circulation unit 300, so that the air is introduced into the mechanism unit 100 through the power supply unit 200 (airflow in the C direction, -X-axis direction, so horizontal airflow). The air cooling the power supply unit 200 is continuously supplied to the mechanism unit 100 and cools the battery cells in the mechanism unit 100. Thereafter, the air in the mechanism unit 100 is discharged to the factory air conditioning device 400 through the other side of the airflow circulation unit 300 (airflow in the D direction, Y-axis direction, so ascending airflow). In this way, by cooling the inside of the charging and discharging device 10 with air and configuring the airflow circulation unit 300, the inside of the charging and discharging device 10 may be cooled more efficiently.

The airflow configuration of the airflow circulation unit 300 includes a descending airflow B, a horizontal airflow C, and an ascending airflow D, as shown, and the air in the airflow circulation unit 300 may be continuously circulated through movements such as descending, horizontal movement, ascending, horizontal movement, and descending by being connected to the factory air conditioning device 400 (here, the airflow circulation may be considered clockwise as exemplified in the drawing).

The air discharged from the mechanism unit 100 through the airflow circulation unit 300 may be recovered by the factory air conditioning device 400 and discharged to the outside of the factory, or may be used to maintain the temperature inside the factory at a certain level through heat exchange. For example, when the outside temperature is lower than the inside temperature, the heated air discharged from the mechanism unit 100 is recycled in the factory air conditioning device 400. When the outside temperature is higher than the inside temperature, the heated air discharged from the mechanism unit 100 is discharged to the outside of the factory.

In this way, the charging and discharging device 10 is characterized in that it connects the factory air conditioning device 400 and the airflow circulation unit 300 to dissipate the heat generation of the charging and discharging device 10. In particular, by directly connecting the factory air conditioning device 400 and the ducts 310, 320, the airflow inside the charging and discharging device 10 may be improved.

In addition, according to the present disclosure, there is an advantage of smoothly maintaining the internal temperature inside the factory. In the past, depending on the supply/return and equipment arrangement of the factory air conditioning device, the air circulation inside the factory may be poor, and a certain location in the factory may have a higher temperature than other locations. According to the present disclosure, regardless of the supply/return and equipment arrangement of the factory air conditioning device 400, the airflow circulation is good, and thus there is no concern that a certain location in the factory may have a higher temperature than other locations.

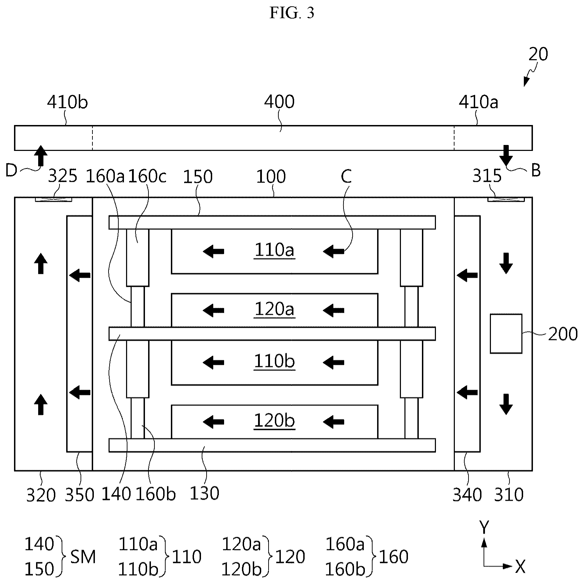

FIG. 3 is a front view of a charging and discharging device according to a second embodiment of the present disclosure.

Referring to FIG. 3, a charging and discharging device 20 is the same as the charging and discharging device 10 described above in that it includes a mechanism unit 100, a power supply unit 200, and an airflow circulation unit 300. Hereinafter, the charging and discharging device 20 will be described mainly focusing on differences from the charging and discharging device 10, so that repeated descriptions will be omitted.

The power supply unit 200 is for charging or discharging battery cells, and various configurations are possible. The power supply unit 200 may be configured to be electrically connected to an external power supply (not shown). The power supply unit 200 performs the role of transmitting power received from an external power supply to the pins. The power supply unit 200 may be configured to include a power case, an electronic circuit, a control unit board, a drive output board, a system auxiliary power supply, an inverter power supply provided with a bidirectional flow and conversion function between AC and DC, and the like.

The mechanism unit 100 includes a pin box portion 110 accommodating the pins. The pin box portion 110 is provided at the bottom of the support portion SM and may have various configurations.

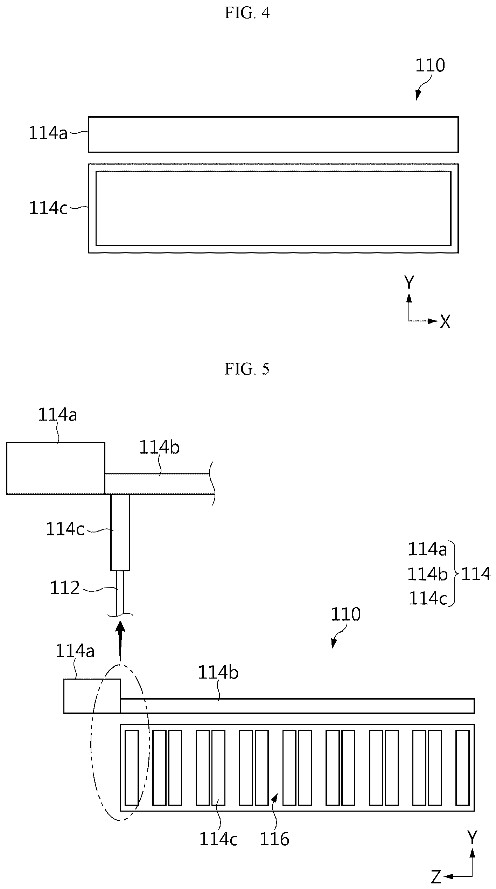

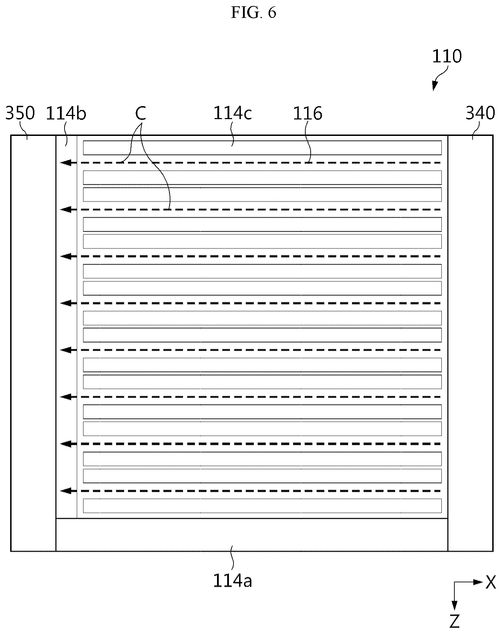

FIG. 4 is a front view of a pin box portion that can be included in the charging and discharging device of FIG. 3. FIG. 5 is a side view of the pin box portion shown in FIG. 4, and FIG. 6 is a top view of the pin box portion shown in FIG. 4.

Referring to FIGS. 4 to 6, the pin box portion 110 includes pins 112 in contact with the battery cells. The pin box portion 110 may be provided in the form of a rectangular cover roughly corresponding to the tray 120, and a board 114 may be mounted therein.

The pins 112 electrically contact the electrode terminals of the battery cells to apply current to the battery cells, thereby allowing the battery cells to store electric energy. Here, the battery cell may be a secondary battery of various structures. For example, the battery cell may be a cylindrical secondary battery.

The pins 112 may be in plurality, and one or more pins may be brought into contact with one battery cell. For example, three pins may be brought into contact with one battery cell to apply current to the battery cell.

The pins 112 of the pin box portion 110 are connected to the power supply unit 200 and brought into contact with the battery cells. For connection of the pins 112 and the power supply unit 200, the pin box portion 110 may include a board 114. The pins 112 may be arranged and mounted on the board 114 corresponding to the battery cells. The pin box portion 110 performs a function of controlling charging and discharging of each battery cell, and a DC/DC voltage conversion and charge/discharge control circuit is mounted on the board 114. The number of battery cells that can be controlled per board 114 is adjustable.

For example, the board 114 may include a voltage conversion/charge/discharge control board 114a, an interface board 114b, and a riser board 114c. And, the voltage conversion/charge/discharge control board 114a, the interface board 114b, the riser board 114c, and the pins 112 may be directly connected by a connector method. The direct connection method may reduce wire connections.

An air circulation passage 116 may be provided in the pin box portion 110 in a direction in which air flows. The air circulation passage 116 may be defined as a rectangular bar-type flow path having a length corresponding to the length or width of the pin box portion 110.

In particular, the air circulation passage 116 may be provided between the voltage conversion/charge/discharge control board 114a, the interface board 114b, and the riser board 114c. The air circulation passage 116 is a plurality of empty spaces formed to correspond to the length or width of the pin box portion 110 to form a flow path through which air flows, thereby increasing the amount of cooling air flowing into the pin box portion 110, and excellently transferring heat generated during charging and discharging of the battery cell to the air. In particular, by disposing an element that generates a lot of heat toward the air circulation passage 116, cooling may be improved.

When the air in the airflow circulation unit 300 passes through the pin box portion 110, it passes through the air circulation passage 116 and then the inside of the pin box portion 110 to form a horizontal airflow (C direction) and may also flow into the battery cell at the bottom of the pin box portion 110, thereby cooling the heat of the pin box portion 110 and the battery cell.

Referring to FIG. 3 again, a tray 120 on which battery cells are seated is inserted and loaded into the mechanism unit 100.

The mechanism unit 100 may include a support portion SM for supporting the pin box portion 110. And, the tray 120 may have a side that is open in a direction in which air flows. The open form may be in the form of a ventilation hole penetrating a portion of the outer wall of the tray 120 or may be in a form where the outer wall itself is substantially perforated in the center with only an edge skeleton. As air flows in and out through the open side of the tray 120, it is possible to smoothly cool the battery cell that may generate heat during charging and discharging. In this way, according to the present disclosure, sufficient air may be introduced to cool the heat of the battery cells, so that the battery cell may be properly cooled. In addition, the air may be efficiently circulated so as to reduce the temperature variation between the battery cells while charging and discharging the battery cells.

The tray 120 may include a bottom surface on which battery cells are mounted and an outer wall around the bottom surface. The bottom surface may be approximately rectangular in shape. A plurality of battery cells may be arranged and mounted in rows and columns on the tray 120. Top end of the tray 120 is open, so that the electrode terminals of the battery cells may be exposed, and the pins 112 of the pin box portion 110 may be brought into contact with them.

Meanwhile, two or more trays 120 may be loaded on the mechanism unit 100 in the upward and downward directions (Y-axis direction). Accordingly, the pin box portion 110 may be configured in two stages. This corresponds to a configuration for improving the layout.

Unlike the conventional method, the mechanism unit of two boxes may be integrated and configured to operate, thereby reducing the equipment height. Two boxes, which were stacked vertically in the past, are integrated into one box, and the battery cells of two trays per box are inserted to perform charging and discharging. According to the present disclosure, the number of charging and discharging devices that can be installed within a given height increases.

To this end, the support portion SM of the mechanism unit 100 of the charging and discharging device 20 may include a lower support portion 140 and an upper support portion 150. The support portion SM may have various shapes, for example, a plate shape.

The upper pin box portion 110a may be supported by the upper support portion 150. The lower pin box portion 110b may be supported by the lower support portion 140. The upper support portion 150 may define a top end portion of the mechanism of the mechanism unit 100.

The upper support portion 150 is configured to be coupled to the upper pin box portion 110a to support the upper pin box portion 110a. The lower surface of the upper support portion 150 may be coupled to the upper pin box portion 110a along the upper surface perimeter direction of the upper pin box portion 110a, and for example, the upper support portion 150 and the upper pin box portion 110a may be coupled by bolting.

Likewise, the lower support portion 140 is configured to be coupled to the lower pin box portion 110b to support the lower pin box portion 110b. The lower surface of the lower support portion 140 may be coupled to the lower pin box portion 110b along the upper surface perimeter direction of the lower pin box portion 110b, and for example, the lower support portion 140 and the lower pin box portion 110b may be coupled by bolting.

The upper tray 120a is seated on the upper surface of the lower support portion 140. The lower support portion 140 may define the upper tray portion.

To seat the lower tray 120b, the mechanism unit 100 may further include a base portion 130. The base portion 130 may define the lower tray portion and at the same time define a bottom end portion of the mechanism of the mechanism unit 100.

The mechanism unit 100 may further include an elevating portion 160. The elevating portion 160 may be further included to lift and lower the pin box portion 110 with respect to the battery cell so that the battery cell may be charged or discharged by the pin box portion 110.

The upper support portion 150 and the lower support portion 140 may be seated on the upper side of the elevating portion 160. Specifically, the upper support portion 150 may be seated on top of the upper elevating portion 160a, and the lower support portion 140 may be seated on top of the lower elevating portion 160b. The upper support portion 150 and the upper pin box portion 110a coupled thereto may move up and down by the upper elevating portion 160a, and the spacing with the upper tray 120a may be adjusted. The upper elevating portion 160a is formed to extend upward from the lower support portion 140. Likewise, the lower support portion 140 and the lower pin box portion 110b coupled thereto may move up and down by the lower elevating portion 160b, and the spacing with the lower tray 120b may be adjusted. The lower elevating portion 160b is formed to extend upward from the base portion 130. The elevating portion 160 may be driven by, for example, a cylinder 160c. For example, it may be driven by a pneumatic or hydraulic actuator. Of course, the driving method of the elevating portion 160 may be a motor method.

The lower support portion 140 and the base portion 130 have an empty space therein, and a driving unit (not shown) that controls the moving speed, moving distance, and the like of the upper support portion 150 and the lower support portion 140 may be accommodated in the empty space. Here, the driving unit may include a motor, an encoder, or the like.

The support portion SM may be moved up and down by the elevating portion 160. As the support portion SM is moved up and down along the elevating portion 160, the support portion SM and the pin box portion 110 connected thereto may move toward the tray 120 (descending, -Y-axis direction) or toward the opposite direction of the tray 120 (ascending, Y-axis direction).

In this way, according to the present disclosure, when two or more trays 120 are loaded in the mechanism unit 100 in the upward and downward directions by improving the layout, there is an advantage in that it becomes easy to adjust the spacing between the pin box portion 110 and the tray 120.

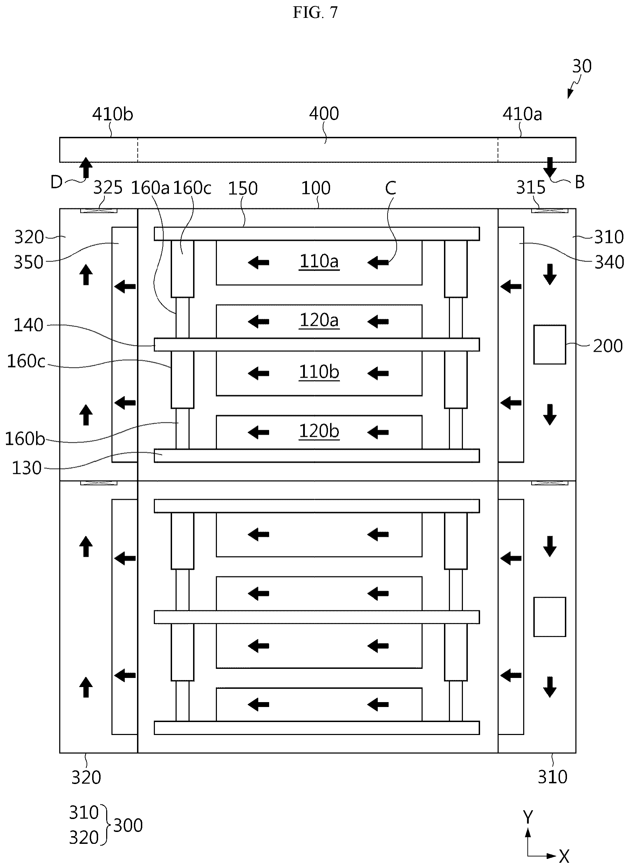

Meanwhile, as shown in FIG. 7, which is a front view of a charging and discharging device according to a third embodiment of the present disclosure, the mechanism unit 100 may be stacked in multiple stages in the upward and downward directions. That is, the charging and discharging device 20 described with reference to FIG. 3 may be stacked in two or more stages to form the charging and discharging device 30.

Hereinafter, the airflow circulation unit 300 will be described in more detail with reference to FIGS. 3 and 7.

As described above, the air in the airflow circulation unit 300 is connected to the factory air conditioning device 400 and circulated.

The supply 410a and return 410b of the factory air conditioning device 400 may be provided above the mechanism unit 100 and the power supply unit 200. Ducts 310, 320 are disposed at places connected to the supply 410a and return 410b of the factory air conditioning device 400.

An intake port 315 for introducing air supplied from the supply 410a of the factory air conditioning device 400 is installed at an upper side of the duct 310 on one side of the pair of ducts 310, 320 included in the airflow circulation unit 300, and an exhaust port 325 for discharging the air to the return 410b of the factory air conditioning device 400 is installed at an upper side of the duct 320 on the other side.

A filter for filtering or diffusing air supplied from the supply 410a of the factory air conditioning device 400 may be further installed in the intake port 315. The air introduced from the intake port 315 is circulated in a downward airflow, diffused in the mechanism unit 100, and then circulated in an upward airflow and discharged toward the exhaust port 325. The charging and discharging device may further include an inlet fan 340 for blowing air introduced from the intake port 315 toward the mechanism unit 100, and an outlet fan 350 for blowing air diffused in the mechanism unit 100 toward the exhaust port 325. The inlet fan 340 supplies air supplied from the supply 410a of the factory air conditioning device 400 toward the mechanism unit 100. Conventional charging and discharging devices do not have a separate cooling device in the mechanism unit, but according to the present disclosure, the cooling air from the intake port 315 may be more smoothly introduced into the mechanism unit 100 by using the inlet fan 340. The outlet fan 350 helps to discharge the heated air inside the mechanism unit 100 to the outside.

The inlet fan 340 and the outlet fan 350 may have a structure and arrangement that allow them to evenly or uniformly blow and discharge air inside the mechanism unit 100. Additionally, it is also possible to control the airflow as necessary by providing a control structure capable of controlling the air volume in each inlet fan 340 and outlet fan 350. To control the air flow, for example, to send a larger amount of air to a place in which the temperature is higher than elsewhere, it is also possible to further control the internal airflow by further including a temperature sensor communicating with this control structure.

The power supply unit 200 is made to be located in the duct 310 connected to the supply 410a of the factory air conditioning device 400. Only the duct 320 is disposed in the place connected to the return 410b of the factory air conditioning device 400 without the power supply unit 200 for smooth air circulation.

Preferably, if a ventilation hole is installed in the tray 120, air introduced from the intake port 315 may be discharged toward the exhaust port 325 through the ventilation hole.

According to this embodiment, the air discharged from the mechanism unit 100 through the airflow circulation unit 300 may be recovered by the factory air conditioning device 400 and discharged to the outside of the factory. If the outside temperature is higher than the inside temperature, the heated air discharged from the mechanism unit 100 is discharged to the outside of the factory. According to the present disclosure, the air is circulated in a downward airflow and an upward airflow through the ducts 310, 320 directly connected to the factory air conditioning device 400, so that the power supply unit 200 and the mechanism unit 100 may be cooled more efficiently.

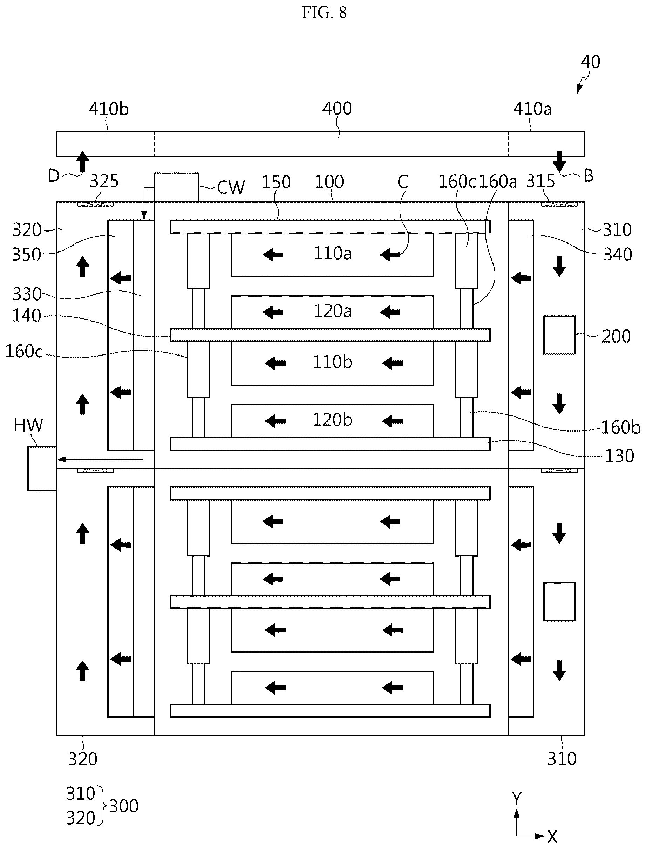

FIG. 8 is a front view of a charging and discharging device according to a fourth embodiment of the present disclosure.

The charging and discharging device 40 of FIG. 8 will be described mainly focusing on differences from the charging and discharging device 30 described above, so that repeated descriptions will be omitted.

The charging and discharging device 40 further includes a heat exchanger 330 in the duct 320 connected to the return 410b of the factory air conditioning device 400. The air discharged from the mechanism unit 100 through the airflow circulation unit 300 may be used to maintain the inside temperature of the factory at a certain level by exchanging heat in the heat exchanger 330. For example, when the outside temperature is lower than the inside temperature, the heated air discharged from the mechanism unit 100 is recycled in the factory air conditioning device 400. The heat exchanger 330 recovers the heat generated during the charging and discharging operation and heats the cold water CW into hot water HW. The hot water HW produced in this way may be utilized where necessary in a factory.

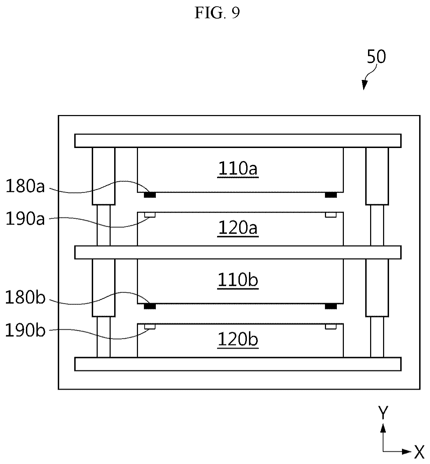

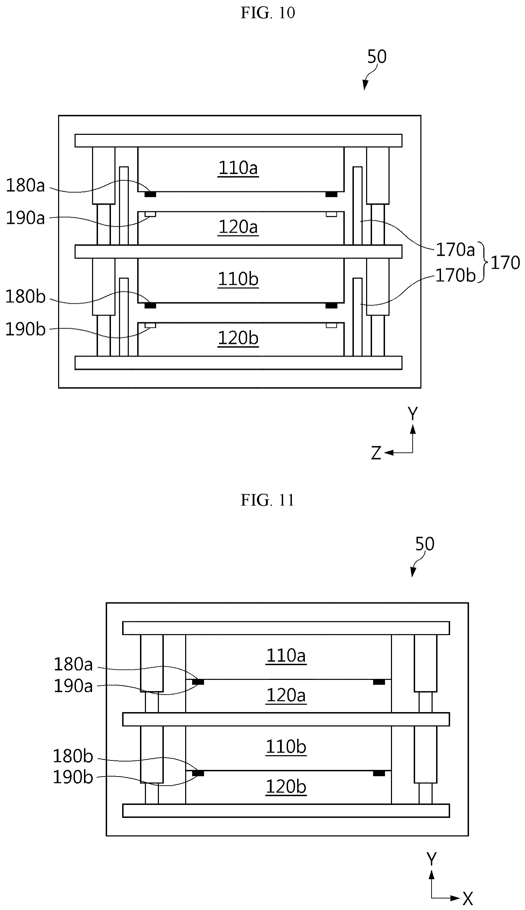

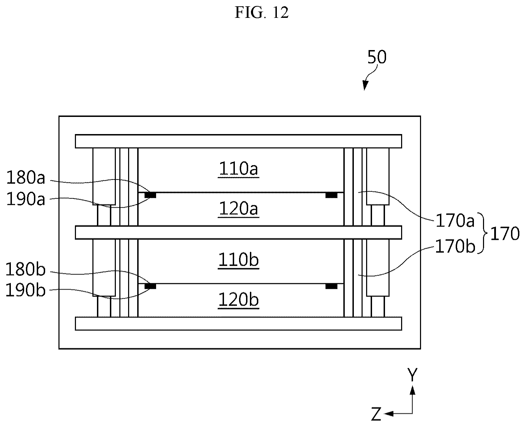

FIGS. 9 to 12 are views for describing a charging and discharging device according to a fifth embodiment of the present disclosure. For convenience of illustration, the power supply unit 200 and the ducts 310, 320 are omitted and the mechanism unit 100 is mainly shown. FIGS. 9 and 10 are a front view and a side view showing a state before support portions of a charging and discharging device touch stoppers, and FIGS. 11 and 12 are a front view and a side view showing a state after support portions of a charging and discharging device touch stoppers.

The charging and discharging device 50 of FIGS. 9 to 12 will be described mainly focusing on differences from the charging and discharging device 20 described above, so that repeated descriptions will be omitted.

Referring to FIGS. 9 to 12, the mechanism unit 100 may further include stoppers 170.

Specifically, an upper stopper 170a may be installed on the lower support portion 140, and a lower stopper 170b may be installed on the base portion 130.

When the upper pin box portion 110a and the upper support portion 150 above the upper pin box portion 110a are lowered (moved down) by the upper elevating portion 160a and touch the upper stopper 170a, the pins 112 of the upper pin box portion 110a may be brought into contact with the battery cells in the upper tray 120a. And, at this time, the upper pin box portion 110a, the upper support portion 150, the upper tray 120a, and the lower support portion 140 below the upper tray 120a are all lowered (moved down) by the elevating portion 160 and when they touch the lower stopper 170b, the pins 112 of the lower pin box portion 110b may be brought into contact with the battery cells in the lower tray 120b.

Guide pins 180a, 180b are installed at the bottom of the upper pin box portion 110a and the bottom of the lower pin box portion 110b, respectively, and grooves 190a, 190b suitable for the guide pins 180a, 180b are provided in the upper tray 120a and the lower tray 120b, respectively. The upper tray 120a and the lower tray 120b may be aligned by configuring that the guide pin 180a of the upper pin box portion 110a enters the groove 190a of the upper tray 120a as the upper pin box portion 110a descends, and the guide pin 180b of the lower pin box portion 110b enters the groove 190b of the lower tray 120b as the lower pin box portion 110b descends.

The guide pins 180a, 180b may be cylindrical members, and the grooves 190a, 190b may be cylindrical grooves. The diameter of the grooves 190a, 190b may be made larger than the diameter of the guide pins 180a, 180b to secure a margin of clearance between alignments. By making the guide pins 180a, 180b cylindrical members rather than members having corners, friction or impact may be prevented even if a slight distortion occurs when the guide pins 180a, 180b are inserted into the grooves 190a, 190b.

The guide pins 180a, 180b may be formed integrally when manufacturing the tray 120 or assembled into the tray 120. For example, when the material of the tray 120 is polycarbonate (PC) resin or acrylonitrile butadiene styrene (ABS) resin, the guide pins 180a, 180b may also be formed of the same material to prevent stress concentration or deformation due to dissimilar materials.

In this way, according to the present disclosure, when two or more trays 120 are loaded in the mechanism unit 100 in the upward and downward directions by improving the layout, there is an advantage in that alignment between the trays 120 becomes easy.

The present disclosure has been hereinabove described with regard to a limited number of embodiments and drawings, but the present disclosure is not limited thereto and various modifications and variations will be possible by those having ordinary skill in the technical field pertaining to the present disclosure within the technical aspect of the present disclosure and the scope of the appended claims and their equivalents.

### [Explanation of Reference Signs]

| | | | |
|---|---|---|---|
| 10, 20, 30, 40, 50: | charging and discharging device | 100: | mechanism unit |
| 110: | pin box portion | 112: | pin |
| 114: | board | 116: | air circulation passage |
| 120: | tray | 130: | base portion |
| 140: | lower support portion | 150: | upper support portion |
| 160: | elevating portion | 170: | stopper |
| 180a, 180b: | guide pin | 190a, 190b: | groove |
| 200: | power supply unit | 300: | airflow circulation unit |
| 310, 320: | duct | 315: | intake port |
| 325: | exhaust port | 330: | heat exchanger |
| 340: | inlet fan | 350: | outlet fan |
| 400: | air conditioning device | | |

## Claims

1. A charging and discharging device, comprising:
a mechanism unit that brings pins for charging and discharging into contact with battery cells;
a power supply unit that is disposed adjacent to the mechanism unit, supplies power and controls charging and discharging; and
an airflow circulation unit that continuously circulates air through the power supply unit to the mechanism unit.

2. The charging and discharging device according to claim 1,
wherein air within the airflow circulation unit is connected to a factory air conditioning device and circulated.

3. The charging and discharging device according to claim 1,
wherein the mechanism unit comprises a pin box portion accommodating the pins, and
the pin box portion is provided with an air circulation passage in a direction in which the air flows.

4. The charging and discharging device according to claim 1,
wherein the mechanism unit comprises a pin box portion accommodating the pins, and
in the pin box portion, a voltage conversion/charge/discharge control board, an interface board, a riser board, and the pins are directly connected by a connector method.

5. The charging and discharging device according to claim **4,**
wherein the pin box portion is provided with an air circulation passage in a direction in which the air flows between the voltage conversion/charge/discharge control board, the interface board, and the riser board.

6. The charging and discharging device according to claim 1,
wherein a tray on which battery cells are seated is loaded in the mechanism unit, and
the tray has a side that is open in a direction in which the air flows.

7. The charging and discharging device according to claim 1,
wherein two or more trays are loaded in the mechanism unit in the upward and downward directions.

8. The charging and discharging device according to claim 1,
wherein the mechanism unit comprises:
an upper pin box portion and a lower pin box portion that accommodate the pins;
an upper support portion that supports the upper pin box portion;
a lower support portion that supports the lower pin box portion and on which an upper tray is seated; and
a base portion on which a lower tray is seated.

9. The charging and discharging device according to claim 8,
wherein the mechanism unit further comprises:
an upper elevating portion formed to extend upward from the lower support portion; and
a lower elevating portion formed to extend upward from the base portion,
wherein the upper support portion is seated on top of the upper elevating portion, and the lower support portion is seated on top of the lower elevating portion.

10. The charging and discharging device according to claim 1,
wherein a supply and a return of a factory air conditioning device are provided above the mechanism unit and the power supply unit, and the airflow circulation unit comprises a pair of ducts,
wherein an intake port for introducing air supplied from the supply of the factory air conditioning device is installed at an upper side of the duct on one side, and
an exhaust port for discharging the air to the return of the factory air conditioning device is installed at an upper side of the duct on the other side.

11. The charging and discharging device according to claim 10,
wherein the power supply unit is located in the duct on one side.

12. The charging and discharging device according to claim 10,
wherein air introduced from the intake port is diffused in the mechanism unit and then discharged toward the exhaust port.

13. The charging and discharging device according to claim 10, further comprising:
an inlet fan for blowing air introduced from the intake port toward the mechanism unit, and
an outlet fan for blowing air diffused in the mechanism unit toward the exhaust port.

14. The charging and discharging device according to claim 10,
wherein a tray is loaded in the mechanism unit, and a ventilation hole is installed in the tray, so that air introduced from the intake port is discharged toward the exhaust port through the ventilation hole.

15. The charging and discharging device according to claim 1,
wherein the mechanism unit is stacked in multiple stages in the upward and downward directions.

16. The charging and discharging device according to claim 10, further comprising:
a heat exchanger in the duct on the other side.

17. The charging and discharging device according to claim 8, further comprising:
an upper stopper installed on the lower support portion; and
a lower stopper installed on the base portion.

18. The charging and discharging device according to claim 9, further comprising:
an upper stopper installed on the lower support portion; and
a lower stopper installed on the base portion,
wherein when the upper pin box portion and the upper support portion are lowered by the upper elevating portion and touch the upper stopper, pins of the upper pin box portion are brought into contact with battery cells in the upper tray.

19. The charging and discharging device according to claim 18,
wherein when the upper pin box portion, the upper support portion, the upper tray, and the lower support portion are lowered and touch the lower stopper, pins of the lower pin box portion are brought into contact with battery cells in the lower tray.

20. The charging and discharging device according to claim 19,
wherein guide pins are installed at the bottom of the upper pin box portion and the bottom of the lower pin box portion, respectively, and grooves suitable for the guide pins are provided in the upper tray and the lower tray, respectively.
